# EUROPEAN PATENT APPLICATION

(11) **EP 4 739 017 A1**
(43) Date of publication of application: **06.05.2026**
(21) Application number: 25211633.0
(22) Date of filing: 28.10.2025
(51) Int. Cl.: H05K 7/20, H02S 40/30, H02S 40/34, H02S 40/42

(54) **PHOTOVOLTAIC OPTIMIZER**

(30) Priority: 29.10.2024 CN 202411527153
(71) Applicant: Huawei Digital Power Technologies Co., Ltd., Shenzhen, Guangdong 518043 (CN)
(72) Inventor: Lin, Yuxuan, Shenzhen, Guangdong, 518043 (CN); ZHAI, Yinhua, Shenzhen, Guangdong, 518043 (CN); CHENG, Jiebin, Shenzhen, Guangdong, 518043 (CN); GU, Guilei, Shenzhen, Guangdong, 518043 (CN); CHEN, Linglin, Shenzhen, Guangdong, 518043 (CN); CAO, Yufan, Shenzhen, Guangdong, 518043 (CN)
(74) Representative: Maiwald GmbH

(57) **Abstract**

This application relates to the field of electronic technologies, and in particular, to a photovoltaic optimizer. The photovoltaic optimizer includes a housing and a circuit board, a power component, a magnetic component, and a metal cover that are accommodated in the housing. A heat exchange layer and a first conductive layer that are spaced apart are embedded in the circuit board. The power component is fastened to a side of the circuit board, is fastened to the heat exchange layer, and is electrically connected to the first conductive layer. The magnetic component and the metal cover are both fastened to a side of the circuit board. The magnetic component is electrically connected to the first conductive layer. The metal cover covers the magnetic component and is fastened and electrically connected to the heat exchange layer. The housing and the metal cover are both filled with a potting adhesive. The potting adhesive covers the circuit board, the power component, the magnetic component, and the metal cover. Heat generated by the power component during operation may be transferred to the metal cover through the heat exchange layer, and then transferred to an external environment through the potting adhesive, to implement heat dissipation of the power component. This helps improve heat dissipation efficiency of the power component.

## Description

### TECHNICAL FIELD

This application relates to the field of electronic technologies, and in particular, to a photovoltaic optimizer.

### BACKGROUND

In an existing photovoltaic optimizer, a power component is mounted on a circuit board, and a temperature equalization plate is in contact with and mounted on a side that is of the power component and that faces away from the circuit board. Heat generated by the power component during operation is transferred to an external environment through the temperature equalization plate, to implement heat dissipation for the temperature equalization plate. However, with an increase in power density of the photovoltaic optimizer, an increasing amount of heat is generated by the power component during operation, and there is a problem of low heat dissipation efficiency of the power component. As a result, a temperature of the power component increases excessively rapidly, and the power component is prone to burnout.

### SUMMARY

This application provides a photovoltaic optimizer, to resolve a problem of low heat dissipation efficiency of a power component.

Embodiments of this application provide a photovoltaic optimizer. The photovoltaic optimizer includes a housing, a circuit board, a power component, a magnetic component, and a metal cover. The circuit board, the power component, the magnetic component, and the metal cover are all accommodated in the housing. A heat exchange layer and a first conductive layer are embedded in the circuit board. The heat exchange layer and the first conductive layer are spaced apart. In a first direction, the power component is fastened to a side of the circuit board, is fastened to the heat exchange layer, and is electrically connected to the first conductive layer. The first direction is a thickness direction of the circuit board. In the first direction, the magnetic component and the metal cover are both fastened to a side of the circuit board. The magnetic component is electrically connected to the first conductive layer. The metal cover covers the magnetic component, is fastened to the heat exchange layer, and is electrically connected to the first conductive layer. The housing and the metal cover are both filled with a potting adhesive. The potting adhesive covers the circuit board, the power component, the magnetic component, and the metal cover.

In the photovoltaic optimizer provided in this embodiment of this application, because the metal cover is fastened to the heat exchange layer and the power component is fastened to the heat exchange layer, heat generated by the power component during operation may be transferred to the metal cover through the heat exchange layer, and then transferred to an external environment through the potting adhesive and the housing, to implement heat dissipation for the power component. As a result, because a contact area between the metal cover and the potting adhesive is large, efficiency of heat exchange between the metal cover and the potting adhesive is high. This helps improve heat dissipation efficiency of the power component. In addition, because the power component is fastened to the heat exchange layer, the power component exchanges heat with the heat exchange layer, and the power component has a capability of double-sided heat dissipation. Specifically, when the photovoltaic optimizer operates, the heat generated by the power component is transferred through the following two paths: The heat is directly dissipated from a surface of the power component to the potting adhesive; and in addition, the heat may also be dissipated from the power component to the heat exchange layer. In this way, the heat of the power component can be quickly dissipated. This helps improve the heat dissipation efficiency of the power component, enhance performance and use safety of the power component, and prolong a service life of the power component.

In addition, because the metal cover covers the magnetic component and is electrically connected to the heat exchange layer, the metal cover may shield a magnetic field generated by the magnetic component during operation, to implement electromagnetic shielding for the magnetic component. The metal cover may implement both electromagnetic shielding for the magnetic component and heat dissipation for the power component. This helps improve utilization of the metal cover, and using different structural members to implement heat dissipation for the power component and electromagnetic shielding for the magnetic component can be avoided. This helps reduce processing costs of the photovoltaic optimizer and reduce a size of the photovoltaic optimizer, and contributes to a miniaturized design of the photovoltaic optimizer.

Moreover, in a design in which the metal cover implements heat dissipation for the power component through the heat exchange layer, while high heat dissipation efficiency of the power component is ensured, the power component may not be in contact with the metal cover, and another component may not be disposed between the power component and the metal cover. A size of the metal cover is not limited by a size of the power component, and the size of the metal cover may be flexibly set. This helps reduce a processing difficulty of the metal cover, reduce processing costs and design costs of the metal cover, and reduce the processing costs of the photovoltaic optimizer.

In a possible implementation, the circuit board is further provided with a heat exchange hole. The heat exchange hole penetrates the circuit board and the heat exchange layer in the first direction. The metal cover includes a mounting portion. The mounting portion surrounds an opening of the metal cover. The mounting portion is in contact with the circuit board and covers the heat exchange hole. The metal cover is further provided with a connection hole. The connection hole penetrates the mounting portion in the first direction and directly communicates with the heat exchange hole. The photovoltaic optimizer further includes a fastener. The fastener connects the connection hole to the heat exchange hole and is configured to fasten the metal cover to the circuit board. The fastener is in contact with the heat exchange layer.

The heat generated by the power component during operation may be transferred to the fastener through the heat exchange layer, and then transferred to the metal cover through the fastener. The heat generated by the power component during operation may be transferred to the external environment through the fastener and the metal cover, to implement the heat dissipation for the power component. The metal cover is fastened to the circuit board through the fastener, so that a structure is simple and stable, and is easy to design. This helps reduce the processing costs of the photovoltaic optimizer.

In a possible implementation, the circuit board is further provided with a heat exchange hole. The heat exchange hole penetrates the circuit board and the heat exchange layer in the first direction. The metal cover is partially inserted into the heat exchange hole and is in contact with and fastened to the heat exchange layer.

In a design in which the metal cover is partially inserted into the heat exchange hole and is in contact with and fastened to the heat exchange layer, the metal cover is fastened to the circuit board by being inserted into the heat exchange hole, so that a structure is simple and stable, and is easy to design. In addition, disposition of an additional mounting component disposed between the metal cover and the circuit board can be avoided. This helps reduce the processing costs of the photovoltaic optimizer. In addition, if the additional mounting component is disposed between the metal cover and the circuit board, a trace cannot be arranged around the mounting component on the circuit board due to a safety requirement. The design in which the metal cover is partially inserted into the heat exchange hole and is in contact with and fastened to the heat exchange layer further helps improve board area utilization of the circuit board, reduce an area of the circuit board, and contributes to miniaturized designs of the circuit board and the photovoltaic optimizer. Moreover, the design in which the metal cover is partially inserted into the heat exchange hole and is in contact with and fastened to the heat exchange layer helps reduce thermal resistance between the metal cover and the heat exchange layer, improve efficiency of transferring the heat generated by the power component during operation to the metal cover through the heat exchange layer, and improve the heat dissipation efficiency of the power component.

In a possible implementation, the circuit board is further provided with a heat exchange hole. The heat exchange hole penetrates the circuit board and the heat exchange layer in the first direction. The metal cover includes a fastening portion. The fastening portion surrounds an opening of the metal cover. The fastening portion is in contact with and fastened to the circuit board and covers the heat exchange hole. A heat exchange material is disposed in the heat exchange hole. The heat exchange material is in contact with and fastened to the fastening portion and the heat exchange layer. A thermal conductivity coefficient of the heat exchange material is greater than a thermal conductivity coefficient of the potting adhesive.

A design in which the fastening portion is in contact with and fastened to the circuit board has a simple and stable structure and is easy to design. In addition, disposition of an additional mounting component between the metal cover and the circuit board can be avoided. This helps reduce the processing costs of the photovoltaic optimizer. In addition, if the additional mounting component is disposed between the metal cover and the circuit board, a trace cannot be arranged around the mounting component on the circuit board due to a safety requirement. The design in which the fastening portion is in contact with and fastened to the circuit board further helps improve board area utilization of the circuit board, reduce an area of the circuit board, and contributes to miniaturized designs of the circuit board and the photovoltaic optimizer.

Heat transferred by the power component to the heat exchange layer may be transferred to the metal cover through the heat exchange material in the heat exchange hole, and then transferred to the external environment through the metal cover, to implement heat dissipation for the power component. A design in which the thermal conductivity coefficient of the heat exchange material is greater than the thermal conductivity coefficient of the potting adhesive helps reduce thermal resistance between the metal cover and the heat exchange layer, improve efficiency of transferring the heat generated by the power component during operation from the heat exchange layer to the metal cover through the heat exchange material, and improve the heat dissipation efficiency of the power component.

In a possible implementation, a projection of the heat exchange hole in the first direction surrounds a projection of the magnetic component in the first direction.

A design in which the projection of the heat exchange hole in the first direction surrounds the projection of the magnetic component in the first direction helps increase a heat exchange area between the heat exchange layer and the metal cover, improve efficiency of heat exchange between the metal cover and the heat exchange layer, improve the efficiency of transferring the heat generated by the power component during operation to the metal cover through the heat exchange layer, and improve the heat dissipation efficiency of the power component.

In a possible implementation, the power component is fastened to a side that is of the circuit board and that faces the magnetic component. The metal cover further covers the power component.

In a design in which the power component is fastened to the side that is of the circuit board and that faces the magnetic component and the metal cover further covers the power component, a case in which the magnetic component and the power component are located on two sides of the circuit board is avoided. This helps improve space utilization, and reduce a size of the photovoltaic optimizer in the thickness direction of the circuit board. In addition, this helps improve board area utilization of the circuit board and reduce the area of the circuit board, and contributes to the miniaturized design of the photovoltaic optimizer.

In a possible implementation, in the first direction, a first thermally conductive material is further disposed between the power component and the metal cover. The first thermally conductive material is in contact with and fastened to the power component and the metal cover separately. A thermal conductivity coefficient of the first thermally conductive material is greater than the thermal conductivity coefficient of the potting adhesive.

In a design in which the first thermally conductive material is in contact with and fastened to the power component and the metal cover separately, the power component is fastened to the metal cover through the first thermally conductive material. This helps improve structural stability and reliability of the photovoltaic optimizer. The heat generated by the power component during operation may further be transferred to the metal cover through the first thermally conductive material, and then transferred to the external environment. A design in which the thermal conductivity coefficient of the first thermally conductive material is greater than the thermal conductivity coefficient of the potting adhesive helps reduce thermal resistance between the power component and the metal cover, improve efficiency of transferring the heat generated by the power component during operation to the metal cover through the first thermally conductive material, and improve the heat dissipation efficiency of the power component.

In a possible implementation, in the first direction, a maximum spacing between the magnetic component and the circuit board is greater than a maximum spacing between the power component and the circuit board. A portion that is of the metal cover and that is opposite to the power component is recessed toward the circuit board.

In the first direction, in a design in which the maximum spacing between the magnetic component and the circuit board is greater than the maximum spacing between the power component and the circuit board and the portion that is of the metal cover and that is opposite to the power component is recessed toward the circuit board, the metal cover may be adaptively designed based on a thickness of the power component and a thickness of the magnetic component, to avoid excessively large space between the power component and the portion that is of the metal cover and that is opposite to the power component. This helps improve space utilization of the metal cover, enhance strength of the metal cover, and improve structural stability of the metal cover.

In a possible implementation, the power component is fastened to a side that is of the circuit board and that faces away from the magnetic component. A projection of the power component in the first direction overlaps a projection of the metal cover in the first direction.

A design in which the power component is fastened to the side that is of the circuit board and that faces away from the magnetic component and the projection of the power component in the first direction overlaps the projection of the metal cover in the first direction helps improve the board area utilization of the circuit board, reduce the area of the circuit board, and contributes to the miniaturized design of the photovoltaic optimizer.

In a possible implementation, the metal cover is further provided with heat dissipation fins. The heat dissipation fins are located on an outer side surface of the metal cover.

A design of the heat dissipation fins helps increase a heat dissipation area of the metal cover, improve efficiency of transferring the heat generated by the power component during operation to the external environment through the metal cover, and improve the heat dissipation efficiency of the power component.

In a possible implementation, the circuit board is further provided with a first through hole. The first through hole penetrates the circuit board and the heat exchange layer in the first direction. The power component includes a first pin. The first pin is inserted into the first through hole and is in contact with and fastened to the heat exchange layer.

In a design in which the first pin is inserted into the first through hole and is in contact with and fastened to the heat exchange layer, the power component is fastened to the circuit board by inserting the first pin into the first through hole, so that a structure is simple and stable, and is easy to design. This helps reduce the processing costs of the photovoltaic optimizer. In addition, the first pin is in contact with and fastened to the heat exchange layer. This helps reduce thermal resistance between the power component and the heat exchange layer, improve efficiency of transferring the heat generated by the power component during operation to the metal cover through the heat exchange layer, and improve the heat dissipation efficiency of the power component.

In a possible implementation, the circuit board is further provided with a first through hole. The first through hole penetrates the circuit board and the heat exchange layer in the first direction. The power component is in contact with and fastened to a surface of the circuit board in the first direction. A second thermally conductive material is disposed in the first through hole. The second thermally conductive material is fastened to the power component and the heat exchange layer. A thermal conductivity coefficient of the second thermally conductive material is greater than the thermal conductivity coefficient of the potting adhesive.

The heat generated by the power component during operation may also be transferred to the heat exchange layer through the second thermally conductive material. The power component exchanges heat with the heat exchange layer in various manners. An appropriate manner may be selected based on a structure of the power component. This helps reduce design difficulty of the photovoltaic optimizer and reduce the processing costs of the photovoltaic optimizer. In addition, a design in which the thermal conductivity coefficient of the second thermally conductive material is greater than the thermal conductivity coefficient of the potting adhesive helps improve efficiency of transferring the heat generated by the power component during operation to the heat exchange layer through the second thermally conductive material, and improve the heat dissipation efficiency of the power component.

In a possible implementation, a second conductive layer is further embedded in the circuit board. The second conductive layer is spaced apart from both the heat exchange layer and the first conductive layer. The metal cover is electrically connected to the second conductive layer. The photovoltaic optimizer further includes a capacitor. In the first direction, the capacitor is fastened to a side of the circuit board. The circuit board is further provided with a mounting hole. The mounting hole penetrates the circuit board and the second conductive layer in the first direction. The capacitor includes a first capacitor pin. The first capacitor pin is inserted into the mounting hole and is fastened and electrically connected to the second conductive layer.

The capacitor may be grounded, or may be electrically connected to another circuit on the circuit board. The capacitor has a stable potential. The capacitor may provide the stable potential for the metal cover through the second conductive layer. This helps improve electromagnetic shielding effect of the metal cover on the magnetic component. In addition, a design in which the first capacitor pin is inserted into the mounting hole and is fastened and electrically connected to the second conductive layer has a simple and stable structure, and is easy to design. This helps reduce the processing costs of the photovoltaic optimizer.

In a possible implementation, a second conductive layer is further embedded in the circuit board. The second conductive layer is spaced apart from both the heat exchange layer and the first conductive layer. The metal cover is electrically connected to the second conductive layer. The photovoltaic optimizer further includes a capacitor. In the first direction, the capacitor is fastened to a side of the circuit board. The circuit board is further provided with a mounting hole. The mounting hole penetrates the circuit board and the second conductive layer in the first direction. The capacitor is in contact with and fastened to a surface of the circuit board in the first direction. A conductive material is disposed in the second through hole. The conductive material is separately fastened and electrically connected to the capacitor and the second conductive layer.

The capacitor may also be fastened and electrically connected to the second conductive layer through the conductive material. The capacitor is electrically connected to the second conductive layer in various manners. An appropriate manner may be selected based on a structure of the capacitor. This helps reduce design difficulty of the photovoltaic optimizer and reduce the processing costs of the photovoltaic optimizer.

In a possible implementation, the circuit board is further provided with a fastening hole. The fastening hole penetrates the circuit board and the second conductive layer in the first direction. The metal cover is further provided with an insertion protrusion. The insertion protrusion is located on an outer side surface of the metal cover. The insertion protrusion is partially inserted into the fastening hole and is fastened and electrically connected to the second conductive layer.

The insertion protrusion is inserted into the fastening hole, so that the metal cover may be fastened and electrically connected to the second conductive layer. The metal cover is fastened and electrically connected to the second conductive layer in various manners. This helps reduce the design difficulty of the photovoltaic optimizer and reduce the processing costs of the photovoltaic optimizer.

### BRIEF DESCRIPTION OF DRAWINGS

To describe the technical solutions in embodiments of this application or in the background more clearly, the following describes the accompanying drawings for describing embodiments of this application or the background.
FIG. 1 is a block diagram of a structure in which a photovoltaic power generation system cooperates with a photovoltaic module and a power grid or load according to an embodiment of this application;
FIG. 2 is a diagram of a structure of a photovoltaic optimizer according to an embodiment of this application;
FIG. 3 is a diagram of a partial three-dimensional structure of the photovoltaic optimizer shown in FIG. 2 (with a potting adhesive omitted);
FIG. 4 is a diagram of a three-dimensional structure of a circuit board of the photovoltaic optimizer shown in FIG. 2;
FIG. 5 is a diagram of a structure of another photovoltaic optimizer according to an embodiment of this application;
FIG. 6 is a diagram of a structure of another photovoltaic optimizer according to an embodiment of this application;
FIG. 7 is a diagram of a structure of another photovoltaic optimizer according to an embodiment of this application;
FIG. 8 is a diagram of a structure of another photovoltaic optimizer according to an embodiment of this application;
FIG. 9 is a diagram of a structure of another photovoltaic optimizer according to an embodiment of this application;
FIG. 10 is a diagram of a structure of another photovoltaic optimizer according to an embodiment of this application; and
FIG. 11 is a diagram of a structure of another photovoltaic optimizer according to an embodiment of this application.

### DESCRIPTION OF EMBODIMENTS

Embodiments of this application provide a photovoltaic optimizer. The photovoltaic optimizer is used in a photovoltaic power generation system. The photovoltaic optimizer in embodiments of this application changes a heat dissipation manner of a power component, to improve heat dissipation efficiency of the power component.

The following describes embodiments of this application with reference to the accompanying drawings in embodiments of this application.

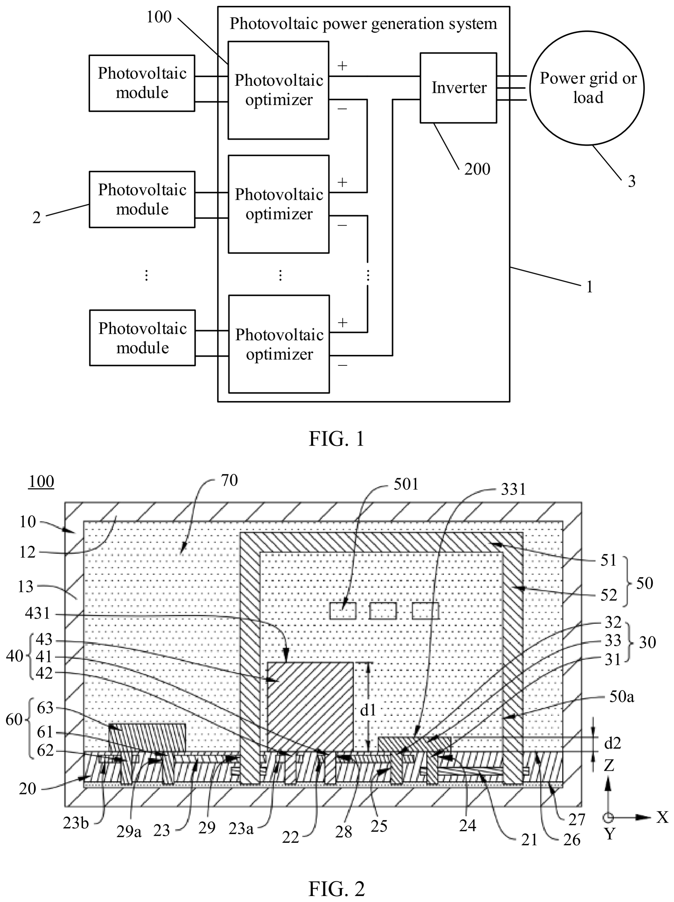

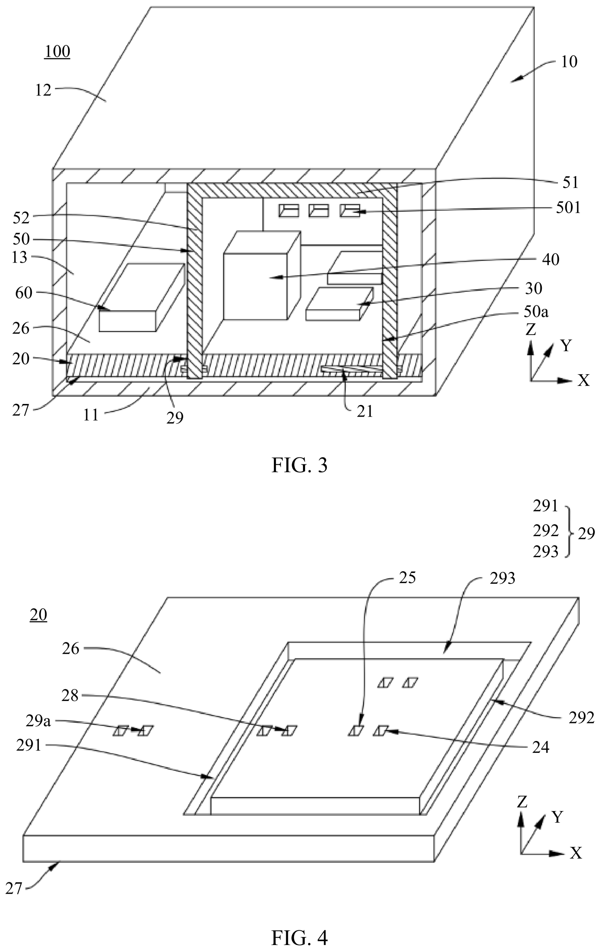

Refer to FIG. 1, FIG. 2, and FIG. 3. FIG. 1 is a block diagram of a structure in which a photovoltaic power generation system 1 cooperates with a photovoltaic module 2 and a power grid or load 3 according to an embodiment of this application. FIG. 2 is a diagram of a structure of a photovoltaic optimizer 100 according to an embodiment of this application. FIG. 3 is a diagram of a partial three-dimensional structure of the photovoltaic optimizer 100 shown in FIG. 2 (with a potting adhesive 70 omitted).

As shown in FIG. 1, the photovoltaic power generation system 1 is configured to: convert a direct current output by the photovoltaic module 2 into an alternating current, and transmit the alternating current to the power grid or load 3, to supply power to the power grid or load 3. The load may be an electronic device that uses an alternating current, for example, a motor, a fan, or an air conditioner. There are a plurality of photovoltaic modules 2, and the plurality of photovoltaic modules 2 are disposed in series. The photovoltaic power generation system 1 includes a plurality of photovoltaic optimizers 100 and an inverter 200. The plurality of photovoltaic optimizers 100 are all electrically connected to the inverter 200, and are electrically connected to the plurality of photovoltaic modules 2 in a one-to-one correspondence. A direct current output by each photovoltaic module 2 is transmitted to the inverter 200 through a corresponding photovoltaic optimizer 100. The inverter 200 is configured to convert the direct current transmitted by the photovoltaic module 2 into an alternating current. The alternating current output by the inverter 200 is transmitted to the power grid or load 3.

In the corresponding photovoltaic optimizer 100 and photovoltaic module 2, the photovoltaic optimizer 100 may step down a voltage and increase a current of the photovoltaic module 2. Due to factors such as light intensity, a temperature, and shading, output power of each photovoltaic module 2 varies. A part of photovoltaic optimizers 100 step down voltages and increase currents of a corresponding part of photovoltaic modules 2, so that the plurality of photovoltaic modules 2 connected in series can output maximum power to the inverter 200, to supply the power to the power grid or load 3. In the corresponding photovoltaic optimizer 100 and photovoltaic module 2, the photovoltaic optimizer 100 may further perform maximum power point tracking (MPPT) on the photovoltaic module 2, to ensure that the photovoltaic module 2 always outputs the maximum power.

As shown in FIG. 1, FIG. 2, and FIG. 3, the photovoltaic optimizer 100 includes a housing 10, a circuit board 20, a power component 30, a magnetic component 40, and a metal cover 50, and further includes a capacitor 60. For ease of description, in this application, any three directions are defined as a first direction (namely, a Z-axis direction shown in the figure), a second direction (namely, an X-axis direction shown in the figure), and a third direction (namely, a Y-axis direction shown in the figure). The first direction (namely, the Z-axis direction shown in the figure) is a thickness direction of the circuit board 20. The first direction (namely, the Z-axis direction shown in the figure), the second direction (namely, the X-axis direction shown in the figure), and the third direction (namely, the Y-axis direction shown in the figure) are perpendicular to each other. In this embodiment, the second direction (namely, the X-axis direction shown in the figure) is a length direction of the circuit board 20, and the third direction (namely, the Y-axis direction shown in the figure) is a width direction of the circuit board 20. In some other embodiments, the second direction (namely, the X-axis direction shown in the figure) may alternatively be the width direction of the circuit board 20, and the third direction (namely, the Y-axis direction shown in the figure) may alternatively be the length direction of the circuit board 20.

The circuit board 20, the power component 30, the magnetic component 40, the metal cover 50, and the capacitor 60 are all accommodated in the housing 10. The housing 10 may include a first cavity wall 11, a second cavity wall 12, and a third cavity wall 13. In the Z-axis direction, the first cavity wall 11 and the second cavity wall 12 are opposite to each other and spaced apart, the third cavity wall 13 is fastened between the first cavity wall 11 and the second cavity wall 12, and the first cavity wall 11, the second cavity wall 12, and the third cavity wall 13 enclose an inner cavity of the housing 10.

The circuit board 20 is located on a side that is of the first cavity wall 11 and that faces the second cavity wall 12, is separately spaced apart from the first cavity wall 11 and the second cavity wall 12, and is fastened to the third cavity wall 13. A heat exchange layer 21 and a first conductive layer 22 are embedded in the circuit board 20, and a second conductive layer 23, a third conductive layer 23a, and a fourth conductive layer 23b are further embedded in the circuit board 20. The heat exchange layer 21, the first conductive layer 22, the second conductive layer 23, the third conductive layer 23a, and the fourth conductive layer 23b are spaced apart from each other. Specifically, in the Z-axis direction, the first conductive layer 22, the second conductive layer 23, the third conductive layer 23a, and the fourth conductive layer 23b are all located on a side of the heat exchange layer 21. In the X-axis direction, the fourth conductive layer 23b, the second conductive layer 23, the third conductive layer 23a, and the first conductive layer 22 are sequentially arranged. A projection of the heat exchange layer 21 in the Z-axis direction surrounds a projection of the first conductive layer 22 in the Z-axis direction and a projection of the third conductive layer 23a in the Z-axis direction. A projection of the second conductive layer 23 in the Z-axis direction partially overlaps the projection of the heat exchange layer 21 in the Z-axis direction, and a projection of the fourth conductive layer 23b in the Z-axis direction and the projection of the heat exchange layer 21 in the Z-axis direction are spaced apart. For example, the heat exchange layer 21 may be made of a metal material including but not limited to copper, aluminum, or an aluminum-copper alloy, or another material having good thermal conductivity; and the first conductive layer 22, the second conductive layer 23, the third conductive layer 23a, and the fourth conductive layer 23b each may be made of a metal material including but not limited to copper, aluminum, or an aluminum-copper alloy, or another material having good electrical conductivity.

In the Z-axis direction (namely, the first direction), the power component 30 is fastened to a side of the circuit board 20, is fastened to the heat exchange layer 21, and is electrically connected to the first conductive layer 22. The power component 30 is further electrically connected to the heat exchange layer 21. In the Z-axis direction (namely, the first direction), the magnetic component 40 and the metal cover 50 are both fastened to a side of the circuit board 20, and the magnetic component 40 is electrically connected to the first conductive layer 22 and is further electrically connected to the third conductive layer 23a. The metal cover 50 covers the magnetic component 40 and is fastened and electrically connected to the heat exchange layer 21, and the metal cover 50 is further electrically connected to the second conductive layer 23. Specifically, the power component 30 is fastened to a side that is of the circuit board 20 and that faces the magnetic component 40, and the metal cover 50 further covers the power component 30. The power component 30 is separately spaced apart from the magnetic component 40 and the metal cover 50. For example, the power component 30, the magnetic component 40, and the metal cover 50 are all fastened to a side that is of the circuit board 20 and that faces away from the first cavity wall 11. In some other embodiments, the power component 30, the magnetic component 40, and the metal cover 50 may alternatively all be fastened to a side that is of the circuit board 20 and that faces away from the second cavity wall 12.

In the Z-axis direction (namely, the first direction), the capacitor 60 is fastened to a side of the circuit board 20, is electrically connected to the second conductive layer 23, and is further electrically connected to the fourth conductive layer 23b. The capacitor 60 is fastened to a side that is of the circuit board 20 and that faces the metal cover 50, and the capacitor 60 is located outside the metal cover 50. In some other embodiments, the capacitor 60 may alternatively be covered by the metal cover 50. The capacitor 60 is electrically connected to the metal cover 50 through the second conductive layer 23, so that the metal cover 50 electromagnetically shields the magnetic component 40.

In the corresponding photovoltaic optimizer 100 and photovoltaic module 2, the photovoltaic module 2 is electrically connected to the power component 30 and the magnetic component 40 through the circuit board 20. The power component 30 cooperates with the magnetic component 40 to step down the voltage and increase the current of the photovoltaic module 2, so that the plurality of photovoltaic modules 2 connected in series can output the maximum power to the power grid or load 3. The power component 30 cooperates with the magnetic component 40, so that maximum power point tracking can also be performed on the photovoltaic module 2. For example, the power component 30 may include but is not limited to an IGBT (Insulated Gate Bipolar Transistor, insulated gate bipolar transistor) chip, an FRD (Fast Recovery Diode, fast recovery diode) chip, a MOSFET (Metal oxide semiconductor field-effect transistor, metal-oxide-semiconductor field-effect transistor) chip, or the like. The magnetic component 40 is an inductor. There may be a plurality of power components 30. For example, there are two power components 30. In some other embodiments, there may be three, four, or more power components 30. The plurality of power components 30 are spaced apart from each other.

The housing 10 and the metal cover 50 are filled with the potting adhesive 70. The potting adhesive 70 may be made of an insulating material including but not limited to epoxy resin, organosilicon, polyurethane, or the like. The potting adhesive 70 covers the circuit board 20, the power component 30, the magnetic component 40, and the metal cover 50, and further covers the capacitor 60. The metal cover 50 is provided with a fitting hole 501, and the potting adhesive 70 in the housing 10 may be filled in the metal cover 50 through the fitting hole 501. As a result, only the potting adhesive 70 needs to be filled in the housing 10 to fill the metal cover 50 with the potting adhesive 70. This helps reduce a filling difficulty of the potting adhesive 70 and reduce processing costs. There may be a plurality of fitting holes 501. For example, there are three fitting holes 501. In some other embodiments, there may alternatively be one, two, four, or more fitting holes 501.

A part of heat generated by the power component 30 during operation is transferred to the metal cover 50 through the heat exchange layer 21, transferred to the housing 10 through the potting adhesive 70 filled in the housing 10, and then transferred to an external environment through the housing 10. Another part of heat is transferred to the metal cover 50 through the potting adhesive 70 filled in the metal cover 50, transferred to the housing 10 through the potting adhesive 70 filled in the housing 10, and then transferred to the external environment through the housing 10, to implement heat dissipation for the power component 30. A contact area between the metal cover 50 and the potting adhesive 70 is large, so that heat can be quickly dissipated from the metal cover 50.

In the photovoltaic optimizer 100 provided in this embodiment of this application, because the metal cover 50 is fastened to the heat exchange layer 21 and the power component 30 is fastened to the heat exchange layer 21, the heat generated by the power component 30 during operation may be transferred to the metal cover 50 through the heat exchange layer 21, and then transferred to the external environment through the potting adhesive 70 and the housing 10, to implement heat dissipation for the power component 30. As a result, because the contact area between the metal cover 50 and the potting adhesive 70 is large, efficiency of heat exchange between the metal cover 50 and the potting adhesive 70 is high. This helps improve heat dissipation efficiency of the power component 30. In addition, because the power component 30 is fastened to the heat exchange layer 21, the power component 30 exchanges heat with the heat exchange layer 21, and the power component 30 has a capability of double-sided heat dissipation. Specifically, when the photovoltaic optimizer 100 operates, the heat generated by the power component 30 is transferred through the following two paths: The heat is directly dissipated from a surface of the power component 30 to the potting adhesive 70; and in addition, the heat may also be dissipated from the power component 30 to the heat exchange layer 21. In this way, the heat of the power component 30 can be quickly dissipated. This helps improve the heat dissipation efficiency of the power component 30, enhance performance and use safety of the power component 30, and prolong a service life of the power component 30.

In addition, because the metal cover 50 covers the magnetic component 40 and is electrically connected to the heat exchange layer 21, the metal cover 50 may shield a magnetic field generated by the magnetic component 40 during operation, to implement electromagnetic shielding for the magnetic component 40. The metal cover 50 may implement both electromagnetic shielding for the magnetic component 40 and heat dissipation for the power component 30. This helps improve utilization of the metal cover 50, and using different structural members to implement heat dissipation for the power component 30 and electromagnetic shielding for the magnetic component 40 can be avoided. This helps reduce processing costs of the photovoltaic optimizer 100 and reduce a size of the photovoltaic optimizer 100, and contributes to a miniaturized design of the photovoltaic optimizer 100.

Moreover, in a design in which the metal cover 50 implements heat dissipation for the power component 30 through the heat exchange layer 21, while high heat dissipation efficiency of the power component 30 is ensured, the power component 30 may not be in contact with the metal cover 50, and another component may not be disposed between the power component 30 and the metal cover 50. A size of the metal cover 50 is not limited by a size of the power component 30, and the size of the metal cover 50 may be flexibly set. This helps reduce a processing difficulty of the metal cover 50, reduce processing costs and design costs of the metal cover 50, and reduce the processing costs of the photovoltaic optimizer 100.

In a design in which the power component 30 is fastened to the side that is of the circuit board 20 and that faces the magnetic component 40 and the metal cover 50 further covers the power component 30, a case in which the magnetic component 40 and the power component 30 are located on two sides of the circuit board 20 is avoided. This helps improve space utilization, and reduce a size of the photovoltaic optimizer 100 in the thickness direction of the circuit board 20 (that is, the Z-axis direction). In addition, this helps improve board area utilization of the circuit board 20 and reduce an area of the circuit board 20, and contributes to the miniaturized design of the photovoltaic optimizer 100. Moreover, the heat generated by the power component 30 during operation may be transferred to the metal cover 50 through the heat exchange layer 21, and then transferred to the external environment through the potting adhesive 70 and the housing 10; and may also be transferred to the metal cover 50 through the potting adhesive 70 and then transferred to the external environment through the potting adhesive 70 and the housing 10. All of the heat generated by the power component 30 during operation is transferred to the metal cover 50 and then transferred to the external environment. This helps improve the heat dissipation efficiency of the power component 30.

The following uses a plurality of embodiments as examples for description.

Refer to FIG. 4. With reference to FIG. 2 and FIG. 3, FIG. 4 is a diagram of a three-dimensional structure of a circuit board 20 of the photovoltaic optimizer 100 shown in FIG. 2.

As shown in FIG. 2, FIG. 3, and FIG. 4, in some embodiments, the circuit board 20 is further provided with a first through hole 24, and the first through hole 24 penetrates the circuit board 20 and the heat exchange layer 21 in the Z-axis direction (namely, the first direction). The power component 30 includes a first pin 31. In a manner including but not limited to soldering or crimping, the first pin 31 is inserted into the first through hole 24 and is in contact with and fastened to the heat exchange layer 21. The first pin 31 is electrically connected to the heat exchange layer 21. In a design in which the first pin 31 is inserted into the first through hole 24 and is in contact with and fastened to the heat exchange layer 21, the power component 30 is fastened to the circuit board 20 by inserting the first pin 31 into the first through hole 24, so that a structure is simple and stable, and is easy to design. This helps reduce the processing costs of the photovoltaic optimizer 100. In addition, the first pin 31 is in contact with and fastened to the heat exchange layer 21. This helps reduce thermal resistance between the power component 30 and the heat exchange layer 21, improve efficiency of transferring the heat generated by the power component 30 during operation to the metal cover 50 through the heat exchange layer 21, and improve the heat dissipation efficiency of the power component 30.

Further, the circuit board 20 is further provided with a second through hole 25, and the second through hole 25 penetrates the circuit board 20 and the first conductive layer 22 in the Z-axis direction (namely, the first direction). The power component 30 further includes a second pin 32, and the second pin 32 and the first pin 31 are spaced apart. In a manner including but not limited to soldering or crimping, the second pin 32 is inserted into the second through hole 25 and is fastened and electrically connected to the first conductive layer 22. The second pin 32 is in contact with the first conductive layer 22. In a design in which the second pin 32 is inserted into the second through hole 25 and is fastened and electrically connected to the first conductive layer 22, the power component 30 is fastened to the circuit board 20 by inserting the second pin 32 into the second through hole 25, so that a structure is simple and stable, and is easy to design. This helps reduce the processing costs of the photovoltaic optimizer 100 and improve structural stability. In addition, the second pin 32 is fastened to the first conductive layer 22. This helps reduce contact resistance between the power component 30 and the first conductive layer 22, and improve through-current efficiency between the power component 30 and the first conductive layer 22.

In the embodiment shown in FIG. 2, FIG. 3, and FIG. 4, the circuit board 20 includes a first surface 26 and a second surface 27. In the Z-axis direction, the first surface 26 and the second surface 27 face away from each other and are spaced apart. The first surface 26 faces away from the first cavity wall 11, and the second surface 27 faces the first cavity wall 11. The first through hole 24 penetrates the heat exchange layer 21 from the first surface 26 in the Z-axis direction and then extends to the second surface 27. The second through hole 25 penetrates the first conductive layer 22 from the first surface 26 in the Z-axis direction and then extends to the second surface 27. The power component 30 further includes a power body 33. In the Z-axis direction, the power body 33 is fastened to a side of the first pin 31 and the second pin 32. In the X-axis direction, the first pin 31 and the second pin 32 are spaced apart. The power body 33 is in contact with and fastened to a side that is of the first surface 26 and that faces away from the second surface 27. For example, in the power component 30, there is one first pin 31 and one second pin 32. There are two first through holes 24 and two second through holes 25, and the two power components 30 each correspond to one first through hole 24 and one second through hole 25. In some other embodiments, in the power component 30, there may be two, three, or more first pins 31 and second pins 32. There may alternatively be three, four, or more first through holes 24 and second through holes 25. Each first through hole 24 corresponds to one first pin 31, and each second through hole 25 corresponds to one second pin 32.

A design in which the power body 33 is fastened to the side of the first pin 31 and the second pin 32 in the Z-axis direction ensures that the power body 33 can cover the first pin 31 and the second pin 32. This helps reduce a board area occupied by the power component 30, reduce an area of the circuit board 20, and contributes to the miniaturized design of the photovoltaic optimizer 100.

In addition, in a design in which the power body 33 is in contact with and fastened to the side that is of the first surface 26 and that faces away from the second surface 27, the circuit board 20 may support the power body 33. This helps improve stability of insertion between the first pin 31 of the power component 30 and the first through hole 24, improve stability of heat exchange between the power component 30 and the heat exchange layer 21, and improve reliability and stability of heat dissipation for the power component 30. In addition, this helps improve stability of insertion between the second pin 32 of the power component 30 and the second through hole 25, improve stability of an electrical connection between the power component 30 and the first conductive layer 22, and improve through-current stability. In some other embodiments, the power body 33 and the first surface 26 may alternatively be spaced apart.

In some embodiments, the circuit board 20 is further provided with a third through hole 28, and the third through hole 28 penetrates the circuit board 20 and the first conductive layer 22 in the Z-axis direction (namely, the first direction). The magnetic component 40 includes a first component pin 41. In a manner including but not limited to soldering or crimping, the first component pin 41 is inserted into the third through hole 28 and is fastened and electrically connected to the first conductive layer 22. The first component pin 41 is in contact with the first conductive layer 22. In a design in which the first component pin 41 is inserted into the third through hole 28 and is fastened and electrically connected to the first conductive layer 22, the magnetic component 40 is fastened to the circuit board 20 by inserting the first component pin 41 into the third through hole 28, so that a structure is simple and stable, and is easy to design. This helps reduce the processing costs of the photovoltaic optimizer 100 and improve structural stability. In addition, the first component pin 41 is fastened to the first conductive layer 22. This helps reduce contact resistance between the magnetic component 40 and the first conductive layer 22, and improve through-current efficiency between the magnetic component 40 and the first conductive layer 22.

Further, the magnetic component 40 further includes a second component pin 42, and the second component pin 42 and the first component pin 41 are spaced apart. The second component pin 42 is fastened and electrically connected to the third conductive layer 23a. The second component pin 42 is in contact with the third conductive layer 23a. For details, refer to a manner in which the first component pin 41 is fastened and electrically connected to the first conductive layer 22. Details are not described again.

In the embodiment shown in FIG. 2, FIG. 3, and FIG. 4, for a structure of the third through hole 28, refer to the descriptions of the second through hole 25. Details are not described again. The magnetic component 40 further includes a component body 43. In the Z-axis direction, the component body 43 is fastened to a side of the first component pin 41 and the second component pin 42. The component body 43 is in contact with and fastened to the side that is of the first surface 26 and that faces away from the second surface 27. For example, there is one third through hole 28 and one first component pin 41. In some other embodiments, there may be a plurality of third through holes 28 and a plurality of the first component pins 41. For example, there may be two, three, or more third through holes 28 and first component pins 41. The plurality of third through holes 28 are in a one-to-one correspondence with the plurality of first component pins 41.

A design in which the component body 43 is fastened to the side of the first component pin 41 in the Z-axis direction ensures that the component body 43 can cover the first component pin 41. This helps reduce a board area occupied by the magnetic component 40, reduce the area of the circuit board 20, and contributes to the miniaturized design of the photovoltaic optimizer 100.

In addition, in a design in which the component body 43 is in contact with and fastened to the side that is of the first surface 26 and that faces away from the second surface 27, the circuit board 20 may support the component body 43. This helps improve stability of insertion between the first component pin 41 and the third through hole 28, improve stability of an electrical connection between the magnetic component 40 and the first conductive layer 22, and improve the through-current stability. In some other embodiments, the component body 43 and the first surface 26 may alternatively be spaced apart.

In some embodiments, the power body 33 (that is, the power component 30) includes a first end face 331, and the component body 43 (that is, the magnetic component 40) includes a second end face 431. The first end face 331 and the second end face 431 both face away from the circuit board 20. In the Z-axis direction, a spacing d1 between the second end face 431 and the first surface 26 (that is, a maximum spacing between the magnetic component 40 and the circuit board 20) is greater than a spacing d2 between the first end face 331 and the first surface 26 (that is, a maximum spacing between the power component 30 and the circuit board 20). In some other embodiments, in the Z-axis direction, the maximum spacing d1 between the magnetic component 40 and the circuit board 20 may alternatively be less than or equal to the maximum spacing d2 between the power component 30 and the circuit board 20. The power component 30 and the magnetic component 40 have various sizes, and the power component 30 and the magnetic component 40 may be flexibly set as required.

In some embodiments, the circuit board 20 is further provided with a heat exchange hole 29, and the heat exchange hole 29 penetrates the circuit board 20 and the heat exchange layer 21 in the Z-axis direction (namely, the first direction). In a manner including but not limited to soldering or crimping, the metal cover 50 is partially inserted into the heat exchange hole 29 and is in contact with and fastened to the heat exchange layer 21. Therefore, the metal cover 50 is electrically connected to the heat exchange layer 21.

Further, the heat exchange hole 29 further penetrates the second conductive layer 23 in the Z-axis direction (namely, the first direction), and the metal cover 50 is fastened and electrically connected to the second conductive layer 23.

Further, a projection of the heat exchange hole 29 in the Z-axis direction (namely, the first direction) surrounds a projection of the magnetic component 40 in the Z-axis direction (namely, the first direction).

In the embodiment shown in FIG. 2, FIG. 3, and FIG. 4, the projection of the heat exchange hole 29 in the Z-axis direction further surrounds a projection of the power component 30 in the Z-axis direction. For example, the heat exchange hole 29 is in a rectangular ring shape. The heat exchange hole 29 includes a first segment 291, a second segment 292, and two third segments 293. In the X-axis direction, the second segment 292 and the first segment 291 are opposite to each other and spaced apart, and the two third segments 293 are both connected to the first segment 291 and the second segment 292. In the Y-axis direction, the two third segments 293 are opposite to each other and spaced apart. The first segment 291 sequentially penetrates the second conductive layer 23 and the heat exchange layer 21 from the first surface 26 in the Z-axis direction and then extends to the second surface 27. The second segment 292 and the two third segments 293 all penetrate the heat exchange layer 21 from the first surface 26 in the Z-axis direction and then extend to the second surface 27.

The metal cover 50 has an opening 50a. The metal cover 50 includes a connection portion 51 and a fastening portion 52. In the Z-axis direction, the fastening portion 52 is fastened to a side of the connection portion 51. In the Z-axis direction, the connection portion 51 is disposed opposite to the opening 50a of the metal cover 50, and the fastening portion 52 surrounds the opening 50a of the metal cover 50. For example, a shape of the fastening portion 52 adapts to a shape of the heat exchange hole 29. Specifically, the fastening portion 52 is in a rectangular ring shape. In some other embodiments, the shape of the fastening portion 52 and the shape of the heat exchange hole 29 may alternatively be a circular ring, a triangular ring, or another specially-shaped ring. In the Z-axis direction, the connection portion 51 is located on a side that is of the power component 30 and that faces away from the circuit board 20, is spaced apart from the power component 30, is located on a side that is of the magnetic component 40 and that faces away from the circuit board 20, and is spaced apart from the magnetic component 40. The fastening portion 52 is partially inserted into the heat exchange hole 29 and is in contact with and fastened to the heat exchange layer 21. In addition, the fastening portion 52 is in contact with, fastened to, and electrically connected to the second conductive layer 23. The fastening portion 52 surrounds and is spaced apart from the power component 30, and surrounds and is spaced apart from the magnetic component 40. The fitting hole 501 penetrates the fastening portion 52 in the Y-axis direction. In some other embodiments, the fitting hole 501 may alternatively penetrate the fastening portion 52 in the X-axis direction. The fitting hole 501 may alternatively penetrate the connection portion 51 in the Z-axis direction.

In a design in which the metal cover 50 is partially inserted into the heat exchange hole 29 and is in contact with and fastened to the heat exchange layer 21, the metal cover 50 is fastened to the circuit board 20 by being inserted into the heat exchange hole 29, so that a structure is simple and stable, and is easy to design. In addition, disposition of an additional mounting component between the metal cover 50 and the circuit board 20 can be avoided. This helps reduce the processing costs of the photovoltaic optimizer 100. In addition, if the additional mounting component is disposed between the metal cover 50 and the circuit board 20, a trace cannot be arranged around the mounting component on the circuit board 20 due to a safety requirement. The design in which the metal cover 50 is partially inserted into the heat exchange hole 29 and is in contact with and fastened to the heat exchange layer 21 further helps improve the board area utilization of the circuit board 20, reduce the area of the circuit board 20, and contributes to miniaturized designs of the circuit board 20 and the photovoltaic optimizer 100. Moreover, the design in which the metal cover 50 is partially inserted into the heat exchange hole 29 and is in contact with and fastened to the heat exchange layer 21 helps reduce thermal resistance between the metal cover 50 and the heat exchange layer 21, improve the efficiency of transferring the heat generated by the power component 30 during operation to the metal cover 50 through the heat exchange layer 21, and improve the heat dissipation efficiency of the power component 30.

In a design in which the heat exchange hole 29 further penetrates the second conductive layer 23 in the Z-axis direction (namely, the first direction) and the metal cover 50 is fastened and electrically connected to the second conductive layer 23, the metal cover 50 only needs to be inserted into the heat exchange hole 29 to exchange heat with the heat exchange layer 21 and to be electrically connected to the second conductive layer 23, so that a structure is simple and is easy to design. This helps simplify a structure of the photovoltaic optimizer 100 and reduce the processing costs of the photovoltaic optimizer 100.

In addition, a design in which the projection of the heat exchange hole 29 in the Z-axis direction (namely, the first direction) surrounds the projection of the magnetic component 40 in the Z-axis direction (namely, the first direction) helps increase a heat exchange area between the heat exchange layer 21 and the metal cover 50, improve efficiency of heat exchange between the metal cover 50 and the heat exchange layer 21, improve the efficiency of transferring the heat generated by the power component 30 during operation to the metal cover 50 through the heat exchange layer 21, and improve the heat dissipation efficiency of the power component 30. In some other embodiments, the projection of the heat exchange hole 29 in the Z-axis direction may alternatively not surround the projection of the magnetic component 40 in the Z-axis direction. For example, the heat exchange hole 29 is a rectangular hole, there may be a plurality of heat exchange holes 29, and the plurality of heat exchange holes 29 are sequentially spaced apart around the power component 30 and the magnetic component 40. In the Z-axis direction, several protrusions may alternatively be provided on an end face that is of the fastening portion 52 and that faces away from the connection portion 51, and the several protrusions are inserted into the plurality of heat exchange holes 29 in a one-to-one correspondence and are all in contact with and fastened to the heat exchange layer 21.

In some embodiments, the circuit board 20 is further provided with a mounting hole 29a, and the mounting hole 29a penetrates the circuit board 20 and the second conductive layer 23 in the Z-axis direction (namely, the first direction). The capacitor 60 includes a first capacitor pin 61. In a manner including but not limited to soldering or crimping, the first capacitor pin 61 is inserted into the second conductive layer 23 and is fastened and electrically connected to the second conductive layer 23. The first capacitor pin 61 is in contact with the second conductive layer 23. The capacitor 60 may be grounded, or may be electrically connected to another circuit on the circuit board 20. The capacitor 60 has a stable potential. The capacitor 60 may provide the stable potential for the metal cover 50 through the second conductive layer 23. This helps improve electromagnetic shielding effect of the metal cover 50 on the magnetic component 40. In addition, a design in which the first capacitor pin 61 is inserted into the mounting hole 29a and is fastened and electrically connected to the second conductive layer 23 has a simple and stable structure and is easy to design. This helps reduce the processing costs of the photovoltaic optimizer 100.

Further, the capacitor 60 further includes a second capacitor pin 62, and the second capacitor pin 62 is fastened and electrically connected to the fourth conductive layer 23b. For details, refer to a manner in which the first capacitor pin 61 is fastened and electrically connected to the second conductive layer 23. Details are not described again.

In the embodiment shown in FIG. 2, FIG. 3, and FIG. 4, the capacitor 60 further includes a capacitor body 63. In the Z-axis direction, the capacitor body 63 is fastened to a side of the first capacitor pin 61 and the second capacitor pin 62. The capacitor body 63 is in contact with and fastened to the side that is of the first surface 26 and that faces away from the second surface 27. For example, there is one mounting hole 29a and one first capacitor pin 61. In some other embodiments, there may be a plurality of mounting holes 29a and a plurality of the first capacitor pins 61, for example, there may be two, three, or more mounting holes 29a and first capacitor pins 61. The plurality of mounting holes 29a are in a one-to-one correspondence with the plurality of first capacitor pins 61.

A design in which the capacitor body 63 is fastened to the side of the first capacitor pin 61 in the Z-axis direction ensures that the capacitor body 63 can cover the first capacitor pin 61. This helps reduce a board area occupied by the capacitor 60, reduce the area of the circuit board 20, and contributes to the miniaturized design of the photovoltaic optimizer 100.

In addition, in a design in which the capacitor body 63 is in contact with and fastened to the side that is of the first surface 26 and that faces away from the second surface 27, the circuit board 20 may support the capacitor body 63. This helps improve stability of insertion between the first capacitor pin 61 and the mounting hole 29a, improve stability of an electrical connection between the capacitor 60 and the second conductive layer 23, and improve stability of electromagnetic shielding of the metal cover 50 on the magnetic component 40. In some other embodiments, the capacitor body 63 and the first surface 26 may alternatively be spaced apart.

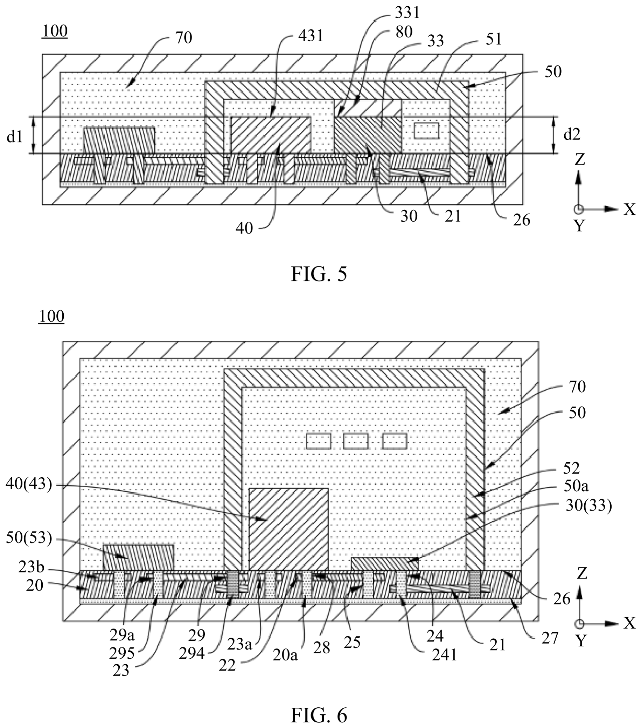

Refer to FIG. 5. With reference to FIG. 2, FIG. 5 is a diagram of a structure of another photovoltaic optimizer 100 according to an embodiment of this application.

As shown in FIG. 2 and FIG. 5, structures in the embodiment shown in FIG. 5 and the embodiment shown in FIG. 2 are similar. A difference between the two structures lies in that a cooperation relationship between a power component 30 and a metal cover 50 varies in the two structures. In the embodiment shown in FIG. 5, in a Z-axis direction (namely, a first direction), a first thermally conductive material 80 is further disposed between the power component 30 and the metal cover 50, and the first thermally conductive material 80 is in contact with and fastened to the power component 30 and the metal cover 50. Specifically, the first thermally conductive material 80 is in contact with and fastened between a connection portion 51 and a power body 33. A thermal conductivity coefficient of the first thermally conductive material 80 is greater than a thermal conductivity coefficient of a potting adhesive 70. For example, the first thermally conductive material 80 may be made of a metal material including but not limited to solder, sintered copper, sintered silver, or another material having good thermal conductivity.

In a design in which the first thermally conductive material 80 is in contact with and fastened to the power component 30 and the metal cover 50 separately, the power component 30 is fastened to the metal cover 50 through the first thermally conductive material 80. This helps improve structural stability and reliability of the photovoltaic optimizer 100. Heat generated by the power component 30 during operation may be transferred to the metal cover 50 through the heat exchange layer 21, and then transferred to an external environment; and may also be transferred to the metal cover 50 through the first thermally conductive material 80, and then transferred to the external environment. A design in which the thermal conductivity coefficient of the first thermally conductive material 80 is greater than the thermal conductivity coefficient of the potting adhesive 70 helps reduce thermal resistance between the power component 30 and the metal cover 50, improve efficiency of transferring the heat generated by the power component 30 during operation to the metal cover 50 through the first thermally conductive material 80, and improve heat dissipation efficiency of the power component 30.

In the embodiment shown in FIG. 5, in the Z-axis direction, a spacing d1 between a second end face 431 and a first surface 26 is less than or equal to a spacing d2 between a first end face 331 and the first surface 26. Specifically, in the Z-axis direction, the spacing d1 between the second end face 431 and the first surface 26 is equal to the spacing d2 between the first end face 331 and the first surface 26. Such a design helps reduce a thickness of the first thermally conductive material 80 (that is, a dimension of the first thermally conductive material 80 in the Z-axis direction), improve structural stability of the first thermally conductive material 80, reduce material costs of the first thermally conductive material 80, and reduce processing costs of the photovoltaic optimizer 100.

Refer to FIG. 6. With reference to FIG. 2, FIG. 6 is a diagram of a structure of another photovoltaic optimizer 100 according to an embodiment of this application.

As shown in FIG. 2 and FIG. 6, structures in the embodiment shown in FIG. 6 and the embodiment shown in FIG. 2 are similar. A difference between the two structures lies in that a cooperation relationship between a metal cover 50 and a heat exchange layer 21, a cooperation relationship between the metal cover 50 and a second conductive layer 23, a cooperation relationship between a power component 30 and the heat exchange layer 21, a cooperation relationship between the power component 30 and a first conductive layer 22, a cooperation relationship between a magnetic component 40 and the first conductive layer 22, a cooperation relationship between the magnetic component 40 and a third conductive layer 23a, a cooperation relationship between a capacitor 60 and the second conductive layer 23, and a cooperation relationship between the capacitor 60 and a fourth conductive layer 23b vary in the two structures. In the embodiment shown in FIG. 6, a heat exchange hole 29 penetrates a circuit board 20 and the heat exchange layer 21 in a Z-axis direction, and the heat exchange hole 29 further penetrates the second conductive layer 23 in the Z-axis direction. In a manner including but not limited to soldering or crimping, a fastening portion 52 is in contact with and fastened to the circuit board 20 and covers the heat exchange hole 29. Specifically, the fastening portion 52 is in contact with and fastened to a first surface 26. A heat exchange material 294 is disposed in the heat exchange hole 29. Specifically, the heat exchange material 294 is filled in the heat exchange hole 29. In some other embodiments, the heat exchange material 294 may alternatively cover a hole wall of the heat exchange hole 29. The heat exchange material 294 is in contact with and fastened to the fastening portion 52 and the heat exchange layer 21. The metal cover 50 is fastened to the heat exchange layer 21 through the heat exchange material 294. In addition, the heat exchange material 294 is further in contact with, fastened to, and electrically connected to the second conductive layer 23. The metal cover 50 is electrically connected to the heat exchange layer 21 through the heat exchange material 294. A thermal conductivity coefficient of the heat exchange material 294 is greater than a thermal conductivity coefficient of a potting adhesive 70. For example, the heat exchange material 294 may be made of a metal material, for example, copper, aluminum, or an aluminum-copper alloy, or another material having good electrical conductivity and thermal conductivity.

A design in which the fastening portion 52 is in contact with and fastened to the circuit board 20 has a simple and stable structure and is easy to design. In addition, disposition of an additional mounting component between the metal cover 50 and the circuit board 20 can be avoided. This helps reduce processing costs of the photovoltaic optimizer 100. In addition, if the additional mounting component is disposed between the metal cover 50 and the circuit board 20, a trace cannot be arranged around the mounting component on the circuit board 20 due to a safety requirement. The design in which the fastening portion 52 is in contact with and fastened to the circuit board 20 further helps improve board area utilization of the circuit board 20, reduce an area of the circuit board 20, and contributes to miniaturized designs of the circuit board 20 and the photovoltaic optimizer 100.

Heat transferred by the power component 30 to the heat exchange layer 21 may be transferred to the metal cover 50 through the heat exchange material 294 in the heat exchange hole 29, and then transferred to an external environment through the metal cover 50, to implement heat dissipation for the power component 30. The metal cover 50 exchanges heat with the heat exchange layer 21 in various manners. This helps reduce design difficulty of the photovoltaic optimizer 100 and reduce the processing costs of the photovoltaic optimizer 100. A design in which the thermal conductivity coefficient of the heat exchange material 294 is greater than the thermal conductivity coefficient of the potting adhesive 70 helps reduce thermal resistance between the metal cover 50 and the heat exchange layer 21, improve efficiency of transferring heat generated by the power component 30 during operation from the heat exchange layer 21 to the metal cover 50 through the heat exchange material 294, and improve heat dissipation efficiency of the power component 30.

In the embodiment shown in FIG. 6, the power component 30 includes only a power body 33. In other words, a first pin 31 and a second pin 32 may be omitted. The power component 30 is in contact with and fastened to a surface of the circuit board 20 in the Z-axis direction (namely, a first direction). Specifically, the power body 33 is in contact with and fastened to the first surface 26. The power component 30 covers a first through hole 24 and a second through hole 25. A second thermally conductive material 241 is disposed in the first through hole 24. Specifically, the second thermally conductive material 241 is filled in the first through hole 24. In some other embodiments, the second thermally conductive material 241 may alternatively cover a hole wall of the first through hole 24. The second thermally conductive material 241 is fastened to the power component 30 and the heat exchange layer 21 and is electrically connected to the power component 30 and the heat exchange layer 21. A thermal conductivity coefficient of the second thermally conductive material 241 is greater than the thermal conductivity coefficient of the potting adhesive 70. The power component 30 is fastened and electrically connected to the heat exchange layer 21 through the second thermally conductive material 241. The second thermally conductive material 241 may be made of a metal material, for example, copper, aluminum, or an aluminum-copper alloy, or another material having good thermal conductivity.

The heat generated by the power component 30 during operation may also be transferred to the heat exchange layer 21 through the second thermally conductive material 241. The power component 30 exchanges heat with the heat exchange layer 21 in various manners. An appropriate manner may be selected based on a structure of the power component 30. This helps reduce the design difficulty of the photovoltaic optimizer 100 and reduce the processing costs of the photovoltaic optimizer 100. In addition, a design in which the thermal conductivity coefficient of the second thermally conductive material 241 is greater than the thermal conductivity coefficient of the potting adhesive 70 helps improve efficiency of transferring the heat generated by the power component 30 during operation to the heat exchange layer 21 through the second thermally conductive material 241, and improve the heat dissipation efficiency of the power component 30.

In the embodiment shown in FIG. 6, the magnetic component 40 includes only a component body 43. In other words, a first component pin 41 and a second component pin 42 may be omitted. The magnetic component 40 is in contact with and fastened to the surface of the circuit board 20 in the Z-axis direction (namely, the first direction). Specifically, the component body 43 is in contact with and fastened to the first surface 26. The magnetic component 40 covers a third through hole 28. An electrical material 20a is disposed in both the second through hole 25 and the third through hole 28. The electrical material 20a in the second through hole 25 is fastened and electrically connected to the power body 33 (that is, the power component 30) and the first conductive layer 22, and the electrical material 20a in the third through hole 28 is fastened and electrically connected to the component body 43 (that is, the magnetic component 40) and the first conductive layer 22. For details, refer to the related descriptions of the second thermally conductive material 241 in the first through hole 24. Details are not described again. The electrical material 20a may be made of a metal material, for example, copper, aluminum, or an aluminum-copper alloy, or another material having good electrical conductivity.

The power component 30 is fastened and electrically connected to the first conductive layer 22 through the electrical material 20a in the second through hole 25. The magnetic component 40 is fastened and electrically connected to the first conductive layer 22 through the electrical material 20a in the third through hole 28. The power component 30 (the magnetic component 40) is electrically connected to the first conductive layer 22 in various manners. An appropriate manner may be selected based on the structure of the power component 30 (the magnetic component 40). This helps reduce the design difficulty of the photovoltaic optimizer 100 and reduce the processing costs of the photovoltaic optimizer 100. For a manner in which the magnetic component 40 is fastened and electrically connected to the third conductive layer 23a, refer to the related descriptions in which the magnetic component 40 is fastened and electrically connected to the first conductive layer 22. Details are not described again.

In the embodiment shown in FIG. 6, the capacitor 60 includes only a capacitor body 63. In other words, a first capacitor pin 61 and a second capacitor pin 62 may be omitted. The capacitor 60 is in contact with and fastened to the surface of the circuit board 20 in the Z-axis direction (namely, the first direction). Specifically, the capacitor body 63 is in contact with and fastened to the first surface 26. The capacitor body 63 covers a mounting hole 29a. A conductive material 295 is disposed in the mounting hole 29a, and the conductive material 295 is fastened and electrically connected to the capacitor 60 and the second conductive layer 23 separately. For details, refer to the related descriptions of the second thermally conductive material 241 in the first through hole 24. Details are not described again. The conductive material 295 may be made of a metal material, for example, copper, aluminum, or an aluminum-copper alloy, or another material having good electrical conductivity.

The capacitor 60 may also be fastened and electrically connected to the second conductive layer 23 through the conductive material 295. The capacitor 60 is electrically connected to the second conductive layer 23 in various manners. An appropriate manner may be selected based on a structure of the capacitor 60. This helps reduce the design difficulty of the photovoltaic optimizer 100 and reduce the processing costs of the photovoltaic optimizer 100. For a manner in which the capacitor 60 is fastened and electrically connected to the fourth conductive layer 23b, refer to the related descriptions in which the capacitor 60 is fastened and electrically connected to the second conductive layer 23. Details are not described again.

It may be understood that, in the embodiment shown in FIG. 6, a design in which the power component 30 is fastened and electrically connected to the heat exchange layer 21 through the second thermally conductive material 241, a design in which the power component 30 and the magnetic component 40 are fastened and electrically connected to the first conductive layer 22 through the electrical material 20a, and a design in which the capacitor 60 is fastened and electrically connected to the second conductive layer 23 through the conductive material 295 may be applied to any one of embodiments shown in FIG. 1 to FIG. 5.

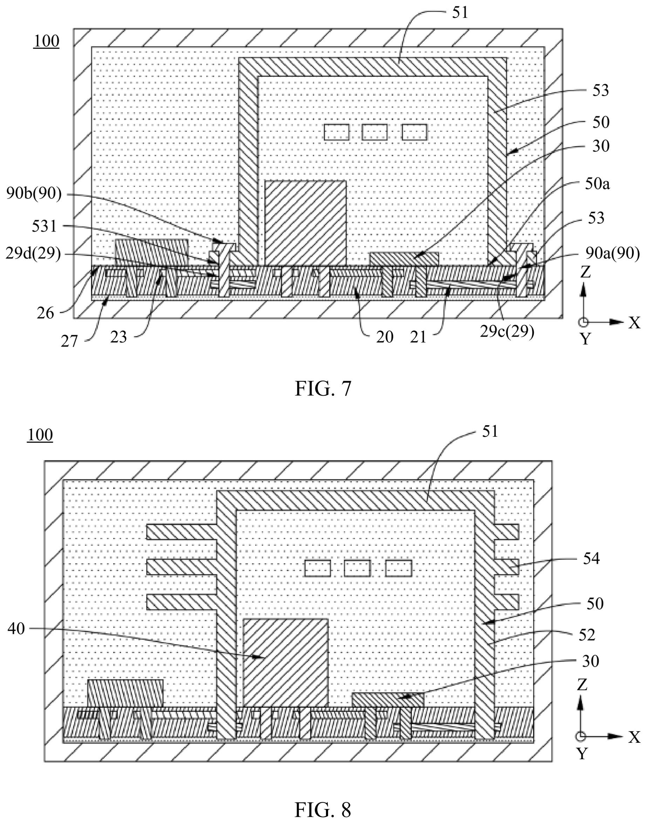

Refer to FIG. 7. With reference to FIG. 2, FIG. 7 is a diagram of a structure of another photovoltaic optimizer 100 according to an embodiment of this application.

As shown in FIG. 2 and FIG. 7, structures in the embodiment shown in FIG. 7 and the embodiment shown in FIG. 2 are similar. A difference between the two structures lies in that a cooperation relationship between a metal cover 50 and a circuit board 20 varies in the two structures. In the embodiment shown in FIG. 7, the circuit board 20 is provided with a heat exchange hole 29, and the heat exchange hole 29 penetrates the circuit board 20 and a heat exchange layer 21 in a Z-axis direction (namely, a first direction). In addition, the heat exchange hole 29 may further penetrate a second conductive layer 23 in the Z-axis direction (namely, the first direction). For example, there are a plurality of heat exchange holes 29, and the plurality of heat exchange holes 29 include a first heat exchange hole 29c and a second heat exchange hole 29d. The first heat exchange hole 29c penetrates the circuit board 20 and the heat exchange layer 21 in the Z-axis direction. Specifically, the first heat exchange hole 29c penetrates the heat exchange layer 21 from a first surface 26 in the Z-axis direction and then extends to a second surface 27. The second heat exchange hole 29d penetrates the circuit board 20, the second conductive layer 23, and the heat exchange layer 21 in the Z-axis direction. Specifically, the second heat exchange hole 29d sequentially penetrates the second conductive layer 23 and the heat exchange layer 21 from the first surface 26 in the Z-axis direction and then extends to the second surface 27.

In the embodiment shown in FIG. 7, the metal cover 50 includes a connection portion 51, a fastening portion 52, and a mounting portion 53. For a cooperation relationship between the connection portion 51 and the fastening portion 52, refer to the related descriptions in the embodiment shown in FIG. 2. Details are not described again. The mounting portion 53 is disposed around the outside of the fastening portion 52, and the mounting portion 53 faces away from an opening 50a of the metal cover 50. The mounting portion 53 surrounds the opening 50a of the metal cover 50. The fastening portion 52 is in contact with the circuit board 20. Specifically, the fastening portion 52 is in contact with the first surface 26 (that is, a surface of the circuit board 20 in the first direction). The mounting portion 53 is in contact with the circuit board 20 and covers the heat exchange hole 29. Specifically, the mounting portion 53 is in contact with the first surface 26.

The metal cover 50 is further provided with a connection hole 531, and the connection hole 531 penetrates the mounting portion 53 in the Z-axis direction (namely, the first direction) and directly communicates with the heat exchange hole 29. For example, there are a plurality of connection holes 531. Specifically, there are two connection holes 531, and the two connection holes 531 directly communicate with the first heat exchange hole 29c and the second heat exchange hole 29d respectively.

The photovoltaic optimizer 100 further includes a fastener 90, and the fastener 90 connects the connection hole 531 to the heat exchange hole 29 and is configured to fasten the metal cover 50 to the circuit board 20. Specifically, the fastener 90 passes through the connection hole 531 and the heat exchange hole 29 and abuts against a side that is of the mounting portion 53 and that faces away from the circuit board 20. The fastener 90 is in contact with the heat exchange layer 21. The fastener 90 is electrically connected to the heat exchange layer 21. In addition, the fastener 90 may further be in contact with and electrically connected to the second conductive layer 23. Specifically, there are a plurality of fasteners 90, and the plurality of fasteners 90 include a first fastener 90a and a second fastener 90b. The first fastener 90a passes through the connection hole 531 and the first heat exchange hole 29c that correspondingly communicate with each other, and abuts against the side that is of the mounting portion 53 and that faces away from the circuit board 20. The first fastener 90a is in contact with and electrically connected to the heat exchange layer 21. The second fastener 90b passes through the connection hole 531 and the second heat exchange hole 29d that correspondingly communicate with each other, and abuts against the side that is of the mounting portion 53 and that faces away from the circuit board 20. The second fastener 90b is in contact with and electrically connected to the heat exchange layer 21, and the second fastener 90b is in contact with and electrically connected to the second conductive layer 23.

Heat generated by a power component 30 during operation may be transferred to the fasteners 90 (the first fastener 90a and the second fastener 90b) through the heat exchange layer 21, and then transferred to the metal cover 50 through the fasteners 90 (the first fastener 90a and the second fastener 90b). The heat generated by the power component 30 during operation may be transferred to an external environment through the fastener 90 and the metal cover 50, to implement heat dissipation for the power component 30. The metal cover 50 is fastened to the circuit board 20 through the fasteners 90 (the first fastener 90a and the second fastener 90b), so that a structure is simple and stable, and is easy to design. This helps reduce processing costs of the photovoltaic optimizer 100.

In a design in which the fastener 90 (that is, the second fastener 90b) is in contact with and electrically connected to the second conductive layer 23, the metal cover 50 is electrically connected to the second conductive layer 23 through the fastener 90 (the second fastener 90b). The metal cover 50 is electrically connected to the second conductive layer 23 in various manners. This helps reduce design difficulty of the photovoltaic optimizer 100 and reduce the processing costs of the photovoltaic optimizer 100.

In the embodiment shown in FIG. 7, the connection hole 531, the heat exchange hole 29, and the fastener 90 are in a one-to-one correspondence, and there are two connection holes 531, two heat exchange holes 29, and two fasteners 90. In some other embodiments, there may be one, three, or more connection holes 531, heat exchange holes 29, and fasteners 90.

It may be understood that, in the embodiment shown in FIG. 7, a design in which the metal cover 50 is mounted on the circuit board 20 through the fastener 90 may be applied to any one of embodiments shown in FIG. 1 to FIG. 6.

Refer to FIG. 8. With reference to FIG. 2, FIG. 8 is a diagram of a structure of another photovoltaic optimizer 100 according to an embodiment of this application.

As shown in FIG. 2 and FIG. 8, structures in the embodiment shown in FIG. 8 and the embodiment shown in FIG. 2 are similar. A difference between the two structures lies in that a structure of a metal cover 50 varies in the two structures. In the embodiment shown in FIG. 8, the metal cover 50 is further provided with heat dissipation fins 54, and the heat dissipation fins 54 are located on an outer side surface that is of the metal cover 50 and that faces away from a magnetic component 40. For example, there may be a plurality of heat dissipation fins 54. In a positive direction of an X axis, a part of the heat dissipation fins 54 may be fastened to a surface that is of a fastening portion 52 and that faces away from the magnetic component 40. In a negative direction of the X axis, the other part of the heat dissipation fins 54 are fastened to a surface that is of the fastening portion 52 and that faces away from the magnetic component 40. In some other embodiments, in a Z-axis direction, the heat dissipation fins 54 may alternatively be fastened to a surface that is of a connection portion 51 and that faces away from the magnetic component 40. A design of the heat dissipation fins 54 helps increase a heat dissipation area of the metal cover 50, improve efficiency of transferring heat generated by a power component 30 during operation to an external environment through the metal cover 50, and improve heat dissipation efficiency of the power component 30.

It may be understood that, in the embodiment shown in FIG. 8, a design in which the metal cover 50 is provided with the heat dissipation fins 54 may be applied to any one of embodiments shown in FIG. 1 to FIG. 7.

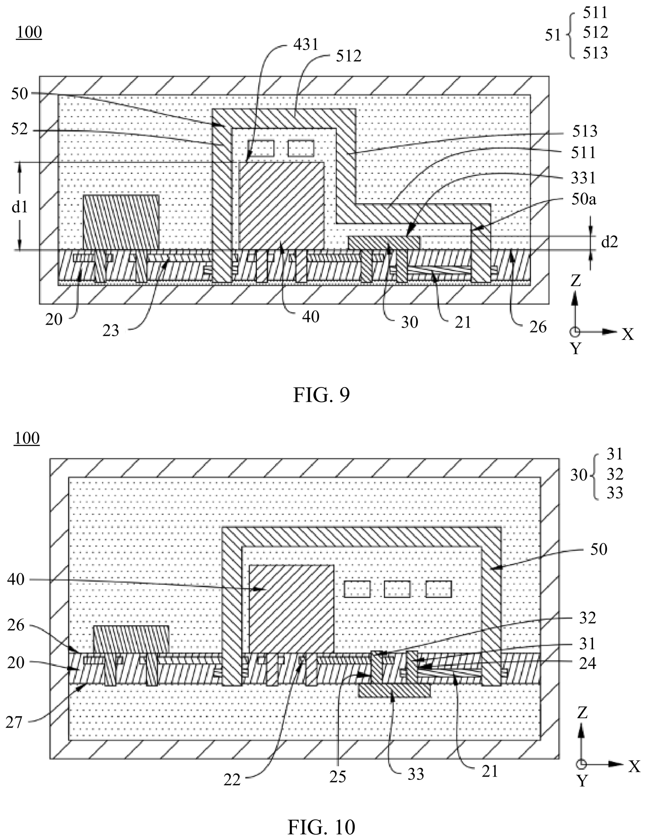

Refer to FIG. 9. With reference to FIG. 2, FIG. 9 is a diagram of a structure of another photovoltaic optimizer 100 according to an embodiment of this application.

As shown in FIG. 2 and FIG. 9, structures in the embodiment shown in FIG. 9 and the embodiment shown in FIG. 2 are similar. A difference between the two structures lies in that a structure of a metal cover 50 varies in the two structures. In the embodiment shown in FIG. 9, in a Z-axis direction (namely, a first direction), a spacing d1 between a second end face 431 and a first surface 26 (that is, a maximum spacing between a magnetic component 40 and a circuit board 20) is greater than a spacing d2 between a first end face 331 and the first surface 26 (that is, a maximum spacing between a power component 30 and the circuit board 20). A portion that is of the metal cover 50 and that is opposite to the power component 30 is recessed toward the circuit board 20.

Specifically, the metal cover 50 includes a connection portion 51 and a fastening portion 52. In the Z-axis direction, the fastening portion 52 is fastened to a side of the connection portion 51. In the Z-axis direction (namely, the first direction), the connection portion 51 is disposed opposite to an opening 50a of the metal cover 50. The fastening portion 52 surrounds the opening 50a of the metal cover 50. In the Z-axis direction (namely, the first direction), the connection portion 51 is located on a side that is of the magnetic component 40 and the power component 30 and that faces away from the circuit board 20, and the connection portion 51 is separately spaced apart from the power component 30 and the magnetic component 40. The fastening portion 52 is fastened to a heat exchange layer 21 and electrically connected to a second conductive layer 23. The fastening portion 52 surrounds and is spaced apart from the power component 30, and surrounds and is spaced apart from the magnetic component 40. For details, refer to the related descriptions in the embodiment shown in FIG. 2. Details are not described again.

In the embodiment shown in FIG. 9, the connection portion 51 includes a first connection portion 511, a second connection portion 512, and a third connection portion 513. In the Z-axis direction (namely, the first direction), the first connection portion 511 and the second connection portion 512 are spaced apart in a staggered manner. In addition, in the Z-axis direction, the first connection portion 511 is located on a side of the second connection portion 512 and spaced apart from the second connection portion 512. The third connection portion 513 is fastened between the first connection portion 511 and the second connection portion 512. In the Z-axis direction (namely, the first direction), the first connection portion 511 is disposed opposite to the power component 30. Specifically, a projection of the first connection portion 511 in the Z-axis direction overlaps a projection of the power component 30 in the Z-axis direction. In the Z-axis direction (namely, the first direction), the second connection portion 512 is disposed opposite to the magnetic component 40. Specifically, a projection of the second connection portion 512 in the Z-axis direction overlaps a projection of the magnetic component 40 in the Z-axis direction. In the Z-axis direction (namely, the first direction), a spacing between the first connection portion 511 and the circuit board 20 is less than the spacing d1 between the second end face 431 and the first surface 26 (that is, the maximum spacing between the magnetic component 40 and the circuit board 20).

In the Z-axis direction (namely, the first direction), in a design in which the maximum spacing d1 between the magnetic component 40 and the circuit board 20 is greater than the maximum spacing d1 between the power component 30 and the circuit board 20 and the portion that is of the metal cover 50 and that is opposite to the power component 30 (that is, the first connection portion 511) is recessed toward the circuit board 20, the spacing between the first connection portion 511 and the circuit board 20 may be less than the maximum spacing d1 between the magnetic component 40 and the circuit board 20. This helps reduce the spacing between the first connection portion 511 and the circuit board 20. The metal cover 50 may be adaptively designed based on a thickness of the power component 30 and a thickness of the magnetic component 40, to avoid excessively large space between the power component 30 and the first connection portion 511 and excessively large space between the portion that is of the metal cover 50 and that is opposite to the power component 30 (that is, the first connection portion 511) and the power component 30. This helps improve space utilization of the metal cover 50, enhance strength of the metal cover 50, and improve structural stability of the metal cover 50.

It may be understood that, in the embodiment shown in FIG. 9, a design in which the portion that is of the metal cover 50 and that is opposite to the power component 30 is recessed toward the circuit board 20 may be applied to any one of embodiments shown in FIG. 1 to FIG. 8.

Refer to FIG. 10. With reference to FIG. 2, FIG. 10 is a diagram of a structure of another photovoltaic optimizer 100 according to an embodiment of this application.

As shown in FIG. 2 and FIG. 10, structures in the embodiment shown in FIG. 10 and the embodiment shown in FIG. 2 are similar. A difference between the two structures lies in that a cooperation relationship between a power component 30 and a circuit board 20 varies in the two structures. In the embodiment shown in FIG. 10, the power component 30 is fastened to a side that is of the circuit board 20 and that faces away from a magnetic component 40. Specifically, a power body 33 is in contact with and fastened to a side that is of a second surface 27 and that faces away from a first surface 26. A first pin 31 is inserted into a first through hole 24 and is in contact with and fastened to a heat exchange layer 21, and a second pin 32 is inserted into a second through hole 25 and is fastened and electrically connected to a first conductive layer 22. A projection of the power component 30 in a Z-axis direction (namely, a first direction) overlaps a projection of a metal cover 50 in the Z-axis direction (namely, the first direction).

A design in which the power component 30 is fastened to the side that is of the circuit board 20 and that faces away from the magnetic component 40 and the projection of the power component 30 in the Z-axis direction (namely, the first direction) overlaps the projection of the metal cover 50 in the Z-axis direction (namely, the first direction) helps improve board area utilization of the circuit board 20, reduce an area of the circuit board 20, and contributes to a miniaturized design of the photovoltaic optimizer 100.

It may be understood that, in the embodiment shown in FIG. 10, the design in which the power component 30 is fastened to the side that is of the circuit board 20 and that faces away from the magnetic component 40 may be applied to any one of embodiments shown in FIG. 1 to FIG. 4, FIG. 6, FIG. 7, and FIG. 8.

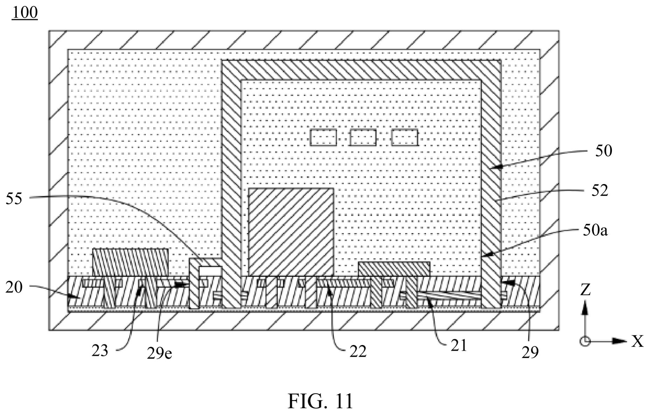

Refer to FIG. 11. With reference to FIG. 2, FIG. 11 is a diagram of a structure of another photovoltaic optimizer 100 according to an embodiment of this application.

As shown in FIG. 2 and FIG. 11, structures in the embodiment shown in FIG. 11 and the embodiment shown in FIG. 2 are similar. A difference between the two structures lies in that a position relationship between a second conductive layer 23 and a heat exchange layer 21, a cooperation relationship between a metal cover 50 and the second conductive layer 23, and a cooperation relationship between the metal cover 50 and the heat exchange layer 21 vary in the two structures. In the embodiment shown in FIG. 11, a projection of the second conductive layer 23 in a Z-axis direction and a projection of the heat exchange layer 21 in the Z-axis direction are spaced apart. Specifically, in an X-axis direction, the second conductive layer 23 is located on a side that is of the heat exchange layer 21 and that faces away from the first conductive layer 22, and is spaced apart from the heat exchange layer 21. A heat exchange hole 29 penetrates a circuit board 20 and the heat exchange layer 21 in the Z-axis direction. A fastening portion 52 is partially inserted into the heat exchange hole 29, and is in contact with, fastened to, and electrically connected to the heat exchange layer 21. The heat exchange hole 29 does not penetrate the second conductive layer 23 in the Z-axis direction.

In the embodiment shown in FIG. 11, the circuit board 20 is further provided with a fastening hole 29e, and the fastening hole 29e penetrates the circuit board 20 and the second conductive layer 23 in the Z-axis direction. The metal cover 50 is further provided with an insertion protrusion 55, and the insertion protrusion 55 is located on an outer side surface of the metal cover 50. Specifically, the insertion protrusion 55 is fastened to a surface that is of the fastening portion 52 and that faces away from an opening 50a of the metal cover 50. The insertion protrusion 55 is partially inserted into the fastening hole 29e and is fastened and electrically connected to the second conductive layer 23. The insertion protrusion 55 is inserted into the fastening hole 29e, so that the metal cover 50 may also be fastened and electrically connected to the second conductive layer 23. The metal cover 50 is fastened and electrically connected to the second conductive layer 23 in various manners. This helps reduce design difficulty of the photovoltaic optimizer 100 and reduce processing costs of the photovoltaic optimizer 100.

It may be understood that, in the embodiment shown in FIG. 11, a design in which the metal cover 50 is fastened and electrically connected to the second conductive layer 23 through the insertion protrusion 55 that is inserted into the fastening hole 29e may be applied to any one of embodiments shown in FIG. 1 to FIG. 10.

## Claims

1. A photovoltaic optimizer, wherein the photovoltaic optimizer comprises a housing, a circuit board, a power component, a magnetic component, and a metal cover, and the circuit board, the power component, the magnetic component, and the metal cover are all accommodated in the housing;
a heat exchange layer and a first conductive layer are embedded in the circuit board, and the heat exchange layer and the first conductive layer are spaced apart;
in a first direction, the power component is fastened to a side of the circuit board, is fastened to the heat exchange layer, and is electrically connected to the first conductive layer, and the first direction is a thickness direction of the circuit board;
in the first direction, the magnetic component and the metal cover are both fastened to a side of the circuit board, the magnetic component is electrically connected to the first conductive layer, and the metal cover covers the magnetic component and is fastened and electrically connected to the heat exchange layer; and
the housing and the metal cover are both filled with a potting adhesive, and the potting adhesive covers the circuit board, the power component, the magnetic component, and the metal cover.

2. The photovoltaic optimizer according to claim 1, wherein the circuit board is further provided with a heat exchange hole, the heat exchange hole penetrates the circuit board and the heat exchange layer in the first direction, the metal cover comprises a mounting portion, the mounting portion surrounds an opening of the metal cover, and the mounting portion is in contact with the circuit board and covers the heat exchange hole; and
the metal cover is further provided with a connection hole, the connection hole penetrates the mounting portion in the first direction and directly communicates with the heat exchange hole, the photovoltaic optimizer further comprises a fastener, the fastener connects the connection hole to the heat exchange hole and is configured to fasten the metal cover to the circuit board, and the fastener is in contact with the heat exchange layer.

3. The photovoltaic optimizer according to claim 1, wherein the circuit board is further provided with a heat exchange hole, the heat exchange hole penetrates the circuit board and the heat exchange layer in the first direction, and the metal cover is partially inserted into the heat exchange hole and is in contact with and fastened to the heat exchange layer.

4. The photovoltaic optimizer according to claim 1, wherein the circuit board is further provided with a heat exchange hole, the heat exchange hole penetrates the circuit board and the heat exchange layer in the first direction, the metal cover comprises a fastening portion, the fastening portion surrounds an opening of the metal cover, and the fastening portion is in contact with and fastened to the circuit board and covers the heat exchange hole; and
a heat exchange material is disposed in the heat exchange hole, the heat exchange material is in contact with and fastened to the fastening portion and the heat exchange layer, and a thermal conductivity coefficient of the heat exchange material is greater than a thermal conductivity coefficient of the potting adhesive.

5. The photovoltaic optimizer according to claim 3 or 4, wherein a projection of the heat exchange hole in the first direction surrounds a projection of the magnetic component in the first direction.

6. The photovoltaic optimizer according to any one of claims 1 to 4, wherein the power component is fastened to a side that is of the circuit board and that faces the magnetic component, and the metal cover further covers the power component.

7. The photovoltaic optimizer according to claim 6, wherein in the first direction, a first thermally conductive material is further disposed between the power component and the metal cover, the first thermally conductive material is in contact with and fastened to the power component and the metal cover separately, and a thermal conductivity coefficient of the first thermally conductive material is greater than the thermal conductivity coefficient of the potting adhesive.

8. The photovoltaic optimizer according to claim 6, wherein in the first direction, a maximum spacing between the magnetic component and the circuit board is greater than a maximum spacing between the power component and the circuit board, and a portion that is of the metal cover and that is opposite to the power component is recessed toward the circuit board.

9. The photovoltaic optimizer according to any one of claims 1 to 4, wherein in the first direction, the power component is fastened to a side that is of the circuit board and that faces away from the magnetic component, and a projection of the power component in the first direction overlaps a projection of the metal cover in the first direction.

10. The photovoltaic optimizer according to any one of claims 1 to 4, wherein the metal cover is further provided with heat dissipation fins, and the heat dissipation fins are located on an outer side surface of the metal cover.

11. The photovoltaic optimizer according to any one of claims 1 to 4, wherein the circuit board is further provided with a first through hole, the first through hole penetrates the circuit board and the heat exchange layer in the first direction, the power component comprises a first pin, and the first pin is inserted into the first through hole and is in contact with and fastened to the heat exchange layer.

12. The photovoltaic optimizer according to any one of claims 1 to 4, wherein the circuit board is further provided with a first through hole, the first through hole penetrates the circuit board and the heat exchange layer in the first direction, the power component is in contact with and fastened to a surface of the circuit board in the first direction, a second thermally conductive material is disposed in the first through hole, the second thermally conductive material is fastened to the power component and the heat exchange layer, and a thermal conductivity coefficient of the second thermally conductive material is greater than the thermal conductivity coefficient of the potting adhesive.

13. The photovoltaic optimizer according to claim 1, wherein a second conductive layer is further embedded in the circuit board, the second conductive layer is spaced apart from both the heat exchange layer and the first conductive layer, and the metal cover is electrically connected to the second conductive layer; and
the photovoltaic optimizer further comprises a capacitor, in the first direction, the capacitor is fastened to a side of the circuit board, the circuit board is further provided with a mounting hole, the mounting hole penetrates the circuit board and the second conductive layer in the first direction, the capacitor comprises a first capacitor pin, and the first capacitor pin is inserted into the mounting hole and is fastened and electrically connected to the second conductive layer.

14. The photovoltaic optimizer according to claim 1, wherein a second conductive layer is further embedded in the circuit board, the second conductive layer and the first conductive layer are spaced apart, and the metal cover is electrically connected to the second conductive layer; and
the photovoltaic optimizer further comprises a capacitor, in the first direction, the capacitor is fastened to a side of the circuit board, the circuit board is further provided with a mounting hole, the mounting hole penetrates the circuit board and the second conductive layer in the first direction, the capacitor is in contact with and fastened to a surface of the circuit board in the first direction, a conductive material is disposed in the mounting hole, and the conductive material is separately fastened and electrically connected to the capacitor and the second conductive layer.

15. The photovoltaic optimizer according to claim 13 or 14, wherein the circuit board is further provided with a fastening hole, the fastening hole penetrates the circuit board and the second conductive layer in the first direction, the metal cover is further provided with an insertion protrusion, the insertion protrusion is located on an outer side surface of the metal cover, and the insertion protrusion is partially inserted into the fastening hole and is fastened and electrically connected to the second conductive layer.
